# EUROPEAN PATENT APPLICATION

(11) **EP 4 704 527 A1**
(43) Date of publication of application: **04.03.2026**
(21) Application number: 25167668.0
(22) Date of filing: 01.04.2025
(51) Int. Cl.: H10H 20/831

(54) **LIGHT-EMITTING DIODE**

(30) Priority: 03.09.2024 TW 113133340
(71) Applicant: Taiwan-Asia Semiconductor Corporation, Hsinchu City 30078 (TW)
(72) Inventor: Cheng, Hong-Ta, 30078 Hsinchu City (TW); Tsai, Ching-Yuan, 30078 Hsinchu City (TW); Huang, Yao-Hong, 30078 Hsinchu City (TW)
(74) Representative: Michalski Hüttermann & Partner Patentanwälte mbB

(57) **Abstract**

The present invention provides a light-emitting diode, which comprises a substrate, a semiconductor light-emitting structure, a P-type electrode and an N-type electrode. The semiconductor light-emitting structure includes a P-type semiconductor layer, a light-emitting layer and an N-type semiconductor layer. The P-type semiconductor layer is located above the substrate, the light-emitting layer is disposed on the P-type semiconductor layer, and the N-type semiconductor layer is disposed on the light-emitting layer. The P-type semiconductor layer has a first side and a second side opposite to each other. The substrate is connected to the first side, and the light-emitting layer is connected to the second side. The P-type electrode is embedded in the P-type semiconductor layer from the second side toward the first side of the P-type semiconductor layer, so that each lateral side of the P-type electrode is at least partially attached to the P-type semiconductor layer. And the N-type electrode is disposed on the N-type semiconductor layer.

## Description

### CROSS REFERENCE TO RELATED APPLICATION

This application claims the benefit of Taiwan Patent Application Serial No. 113133340 filed on September 3, 2024. The entirety of the Application is incorporated herein by reference.

### BACKGROUND OF THE INVENTION

### 1. Field of the Invention

The present invention relates to a light-emitting diode, especially a light-emitting diode with a reduced electrode linewidth and lowered resistance.

### 2. Description of Related Art

In recent years, light-emitting diodes have been widely applied in various fields or products with lighting requirements. Currently, common light-emitting diodes produce an electroluminescence effect to convert electrical energy into light energy, mainly by applying electric currents to pass through a connection surface between two different semiconductor materials. This makes the light-emitting diodes not only emit high-brightness light but also have an energy and power saving effect.

For a conventional red light-emitting diode, a P-type semiconductor layer, a light-emitting layer, an N-type semiconductor layer and an N-type electrode are sequentially stacked on a substrate and the P-type electrode is disposed on the exposed P-type semiconductor layer. The P-type electrode must have a sufficient electrode linewidth and is opaque, so a light-emitting area of the red light-emitting diode is reduced, due to being blocked by the P-type electrode, which makes it difficult to increase overall brightness of the light-emitting diode.

In light of this, it is really worthy of research and development to design a light-emitting diode for solving the above-mentioned problems.

### SUMMARY OF THE INVENTION

An objective of the present invention is to provide a light-emitting diode with a reduced electrode linewidth and lowered resistance.

To achieve the above-mentioned objective, the light-emitting diode of the present invention comprises a substrate, a semiconductor light-emitting structure, a P-type electrode and an N-type electrode. The semiconductor light-emitting structure includes a P-type semiconductor layer, a light-emitting layer and an N-type semiconductor layer. Wherein the P-type semiconductor layer is located above the substrate, the light-emitting layer is disposed on the P-type semiconductor layer, and the N-type semiconductor layer is disposed on the light-emitting layer. And wherein the P-type semiconductor layer has a first side and a second side opposite to each other, the substrate is connected to the first side, and the light-emitting layer is connected to the second side. The P-type electrode is embedded in the P-type semiconductor layer from the second side toward the first side of the P-type semiconductor layer, so that each lateral side of the P-type electrode is at least partially attached to the P-type semiconductor layer. And the N-type electrode is disposed on the N-type semiconductor layer.

In one embodiment of the present invention, the second side of the P-type semiconductor layer has a setting region, and the setting region is an accommodation space extending from a surface of the second side toward the first side to a default depth.

In one embodiment of the present invention, the default depth is less than a thickness of the P-type semiconductor layer and does not exceed 10 µm.

In one embodiment of the present invention, the setting region maintains a distance in a horizontal direction away from the light-emitting layer and the N-type semiconductor layer of the semiconductor light-emitting structure.

In one embodiment of the present invention, the P-type semiconductor layer is made of P-type gallium phosphide material, and the N-type semiconductor layer is made of N-type aluminum gallium indium phosphide material.

In one embodiment of the present invention, a cross-sectional area of the P-type electrode along a horizontal direction is not less than 3% of a total cross-sectional area of the light-emitting diode along the horizontal direction.

In one embodiment of the present invention, a default wavelength of the semiconductor light-emitting structure is between 590 nm and 1050 nm.

In one embodiment of the present invention, the light-emitting diode further comprises a bonding layer sandwiched between the substrate and the P-type semiconductor layer, and the bonding layer is made of silicon dioxide material.

In one embodiment of the present invention, the P-type electrode is made of beryllium gold alloy material or zinc gold alloy material.

In one embodiment of the present invention, the substrate is a sapphire substrate.

With the above design, through embedding the P-type electrode in the P-type semiconductor layer to increase the contact area between the P-type electrode and the P-type semiconductor layer for the light-emitting diode of the present invention, the resistance of the P-type electrode is lowered and the electrode linewidth of the P-type electrode can be reduced in terms of circuit design, thereby increasing the light-emitting area to improve overall brightness of the light-emitting diode.

### BRIEF DESCRIPTION OF THE DRAWINGS

FIG. 1 is a top view of a light-emitting diode according to the present invention;
FIG. 2 is a cross-sectional view along a line segment A-A shown in FIG. 1 of the light-emitting diode according to the present invention;
FIG. 3 is a schematic view of manufacturing the light-emitting diode according to the present invention.

### DETAILED DESCRIPTION OF THE PREFERRED EMBODIMENT

Since various examples and embodiments in the present invention are only illustrative and non-restrictive, a person skilled in the art can easily conceive other examples and embodiments without contravening the scope of the present invention, after reading this specification, and can make the features and advantages of these embodiments more evident based on the following detailed description and claims.

Herein, the description of unit, element and component in the present invention uses "one", "a", or "an". This is for convenience and for offering general meaning of the category of the present invention. Therefore, the description should be understood as including "one", "at least one", and singular and plural forms at the same time unless the context clearly indicates otherwise.

Herein, the description of the terms "first" or "second" and similar ordinal numbers are mainly used to distinguish or refer to the same or similar elements or structures and do not necessarily imply that such components or structures are spatially or temporally distinct order. It should be understood that ordinal numbers, in certain situations or configurations, may be used interchangeably without affecting the implementation of the present invention.

Herein, the description of "comprise", "have" or other similar semantics have the non-exclusive meaning. For example, components or structures with a plurality of elements are not only limited to those disclosed in this specification, but also include generally inherent elements, which are not explicitly listed here for the components or the structures.

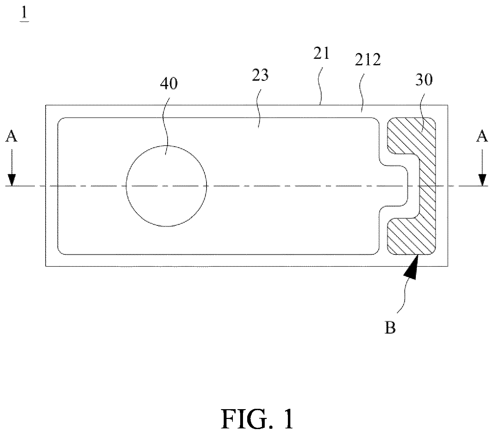

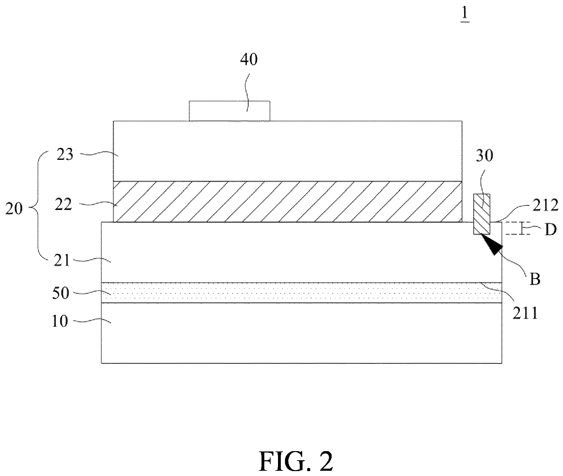

Please refer to FIG. 1 and FIG. 2 together. FIG. 1 is a top view of a light-emitting diode of the present invention, and FIG. 2 is a cross-sectional view along a line segment A-A shown in FIG. 1 of the light-emitting diode of the present invention. As shown in FIG. 1 and FIG. 2, a light-emitting diode 1 of the present invention mainly comprises a substrate 10, a semiconductor light-emitting structure 20, a P-type electrode 30 and an N-type electrode 40. The substrate 10 is a basic structure of the light-emitting diode 1 of the present invention, and is utilized to carry the semiconductor light-emitting structure 20, the P-type electrode 30, the N-type electrode 40 and other components. In the present invention, the substrate 10 is made of one side polished sapphire, but the substrate 10 can also be made of other common substrate materials.

The semiconductor light-emitting structure 20 is located above the substrate 10, and is utilized to emit light with a default wavelength after voltage is applied thereto. The semiconductor light-emitting structure 20 is an epitaxial stack structure and includes a P-type semiconductor layer 21, a light-emitting layer 22 and an N-type semiconductor layer 23. The P-type semiconductor layer 21 is located above the substrate 10, the light-emitting layer 22 is disposed on the P-type semiconductor layer 21, and the N-type semiconductor layer 23 is disposed on the light-emitting layer 22. In one embodiment of the present invention, the P-type semiconductor layer 21 is made of P-type gallium phosphide (P-GaP) material, the light-emitting layer 22 is a multiple-quantum well (MQW) layer, and the N-type semiconductor layer 23 is made of N-type aluminum gallium indium phosphide (N-AlGaInP) material. Accordingly, the semiconductor light-emitting structure 20 is presented as a P-MQW-N epitaxial stack structure.

The P-type semiconductor layer 21 mainly has a first side 211 and a second side 212 opposite to each other. The first side 211 faces and is close to the substrate 10, and the second side 212 faces away and is far from the substrate 10. The P-type semiconductor layer 21 is connected to the substrate 10 through the first side 211, and the P-type semiconductor layer 21 is connected to the light-emitting layer 22 and the P-type electrode 30 through the second side 212. In the present invention, the P-type electrode 30 is partially embedded in the P-type semiconductor layer 21 from the second side 212 toward the first side 211 (or toward the substrate 10) of the P-type semiconductor layer 21, so that each lateral side of the P-type electrode 30 is at least partially attached to the P-type semiconductor layer 21, to increase a contact area between the P-type electrode 30 and the P-type semiconductor layer 21.

Furthermore, in one embodiment of the present invention, the second side 212 of the P-type semiconductor layer 21 has a setting region B. The setting region B is an accommodation space, extending from a surface of the second side 212 toward the first side 211 to a default depth D, for the P-type electrode 30 to be placed therein, so that the P-type electrode 30 is at least partially buried in the P-type semiconductor layer 21. In one embodiment of the present invention, the default depth D is less than a thickness of the P-type semiconductor layer 21, and the default depth D does not exceed 10 µm. In terms of structural design, the setting region B maintains a distance in a horizontal direction away from the light-emitting layer 22 and the N-type semiconductor layer 23 of the semiconductor light-emitting structure 20, without any direct contact.

Accordingly, by embedding the P-type electrode 30 in the P-type semiconductor layer 21, the contact area between the P-type electrode 30 and the P-type semiconductor layer 21 can be effectively increased to lower resistance thereof, and thus an electrode linewidth of the P-type electrode 30 is not necessary to be increased in its original design and is even possible to be further reduced for decreasing an electrode area thereof, thereby increasing a light-emitting area thereof. In addition, in one embodiment of the present invention, the P-type electrode 30 is made of beryllium gold (BeAu) alloy material or zinc gold (ZnAu) alloy material, but not limited thereto.

In terms of design, the electrode area occupied by the P-type electrode 30 of the light-emitting diode 1 of the present invention has specific conditions compared to a die area of the light-emitting diode 1 of the present invention. In order to prevent voltage of the die of the light-emitting diode 1 of the present invention from being high, in one embodiment of the present invention, a cross-sectional area of the P-type electrode 30 along the horizontal direction (that is, corresponding to an area of the setting region B in FIG. 1) is not less than 3% of a total cross-sectional area of the light-emitting diode 1 along the horizontal direction (that is, corresponding to a cross-sectional area along the horizontal direction of the P-type semiconductor layer 21 in FIG. 1 and FIG. 2), thus for providing a voltage stabilization effect. Preferably, in one embodiment of the present invention, the cross-sectional area of the P-type electrode 30 along the horizontal direction is approximately between 3% and 20% of the total cross-sectional area along the horizontal direction of the light-emitting diode 1.

The N-type electrode 40 is disposed on the N-type semiconductor layer 23. In one embodiment of the present invention, the N-type electrode 40 is made of common metals, such as gold (Au), nickel (Ni) or germanium (Ge), but it can also be made of other metals or alloy materials.

The aforementioned semiconductor light-emitting structure 20 emits light with the default wavelength, and the corresponding default wavelength changes according to the materials used in the semiconductor light-emitting structure 20. In one embodiment of the present invention, the default wavelength of the semiconductor light-emitting structure 20 is between 590 nm and 1050 nm. That is to say, the semiconductor light-emitting structure 20 of the light-emitting diode 1 of the present invention emits corresponding light within a red light wavelength band.

In addition, in one embodiment of the present invention, the light-emitting diode 1 of the present invention further comprises a bonding layer 50. The bonding layer 50 is sandwiched between the substrate 10 and the P-type semiconductor layer 21 of the semiconductor light-emitting structure 20. The bonding layer 50 is made of silicon dioxide (SiO₂) material. By the bonding layer 50, a surface bonding effect is better provided between the substrate 10 and the semiconductor light-emitting structure 20. However, the present invention is not limited thereto. The bonding layer 50 may also be made of other materials that can provide similar effects.

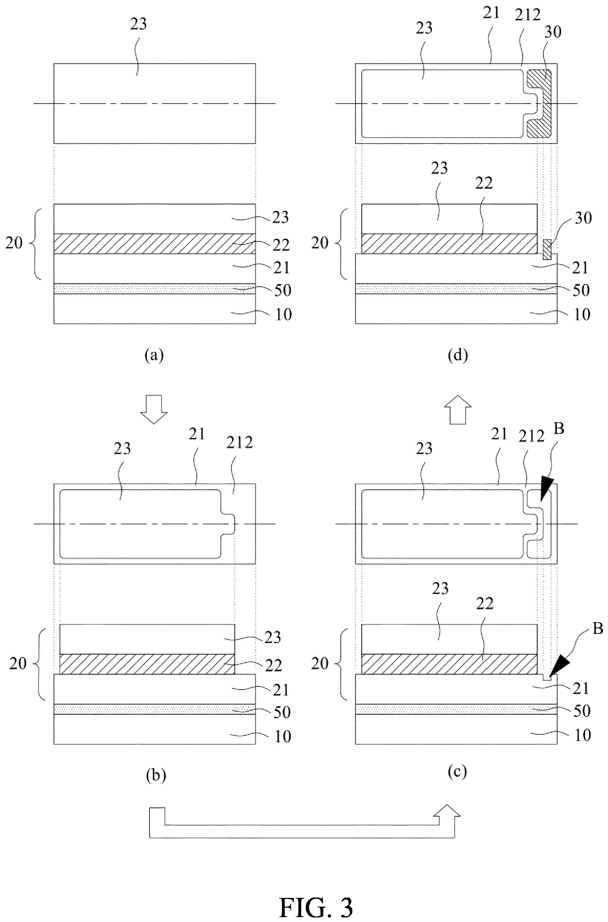

Relevant manufacturing processes of the light-emitting diode 1 of the present invention are described as below. Please refer to FIG. 3, which is a schematic view of manufacturing the light-emitting diode of the present invention. As shown in FIG. 3, a gallium arsenide (GaAs) substrate is first provided as an epitaxial base, and a semiconductor epitaxial process is performed on the gallium arsenide substrate to form the P-type semiconductor layer 21, the light-emitting layer 22 and the N-type semiconductor layer 23 of the semiconductor light-emitting structure 20 mentioned above. Next, a surface roughening process is performed on an exposed side of the P-type semiconductor layer 21, and the bonding layer 50 is formed on the exposed side after being roughened, so that the substrate 10 and the semiconductor light-emitting structure 20 are bonded to each other through the bonding layer 50. After the substrate 10 and the semiconductor light-emitting structure 20 are bonded, the gallium arsenide substrate can be removed and a structure shown as (a) in FIG. 3 is presented. Moreover, a mesa process is performed on the semiconductor light-emitting structure 20, so that a planar area of the semiconductor light-emitting structure 20 is created for forming the setting region B on the second side 212 of the P-type semiconductor layer 21, and a structure shown as (b) in FIG. 3 appears.

After the mesa process is performed, a photolithography process and a dry (or wet) etching process on the semiconductor light-emitting structure 20 are next carried to form the setting region B with the default depth on the second side 212 of the P-type semiconductor layer 21, and a structure shown as (c) in FIG. 3 occurs. Then, another photolithography process and an evaporation process are cooperatively performed to form the P-type electrode 30 embedded in the setting region B of the P-type semiconductor layer 21 to the default depth, and a structure shown as (d) in FIG. 3 is formed. Finally, a similar photolithography process and a similar evaporation process are performed to form an N-type electrode 40 on the N-type semiconductor layer 23, and the light-emitting diode 1 shown in FIG. 1 and FIG. 2 is obtained, so that the relevant manufacturing processes for the light-emitting diode 1 of the present invention are then roughly completed.

With the above design, through embedding the P-type electrode in the P-type semiconductor layer to increase the contact area between the P-type electrode and the P-type semiconductor layer for the light-emitting diode of the present invention, the resistance of the P-type electrode is lowered and the electrode linewidth of the P-type electrode can be reduced in terms of circuit design, thereby increasing the light-emitting area to improve overall brightness of the light-emitting diode.

The above implementations are only auxiliary descriptions, and are not intended to limit the embodiments of the application subject or the applications or uses of the embodiments. In addition, although at least one illustrative example has been presented above, it should be understood that the present invention can still have a large quantity of variations. It should also be understood that the embodiments described herein are not intended to limit the scope, use, or configuration of the requested subject matter in any way. On the contrary, the foregoing embodiments will provide a convenient guide for those skilled in the art to implement one or more embodiments. Furthermore, various changes can be made to the function and arrangement of the components without departing from the scope defined by the patent claims, and the scope of the patent claims includes known equivalents and all foreseeable equivalents at the time that the patent application is filed.

## Claims

1. A light-emitting diode, comprising:
a substrate,
a semiconductor light-emitting structure, including a P-type semiconductor layer, a light-emitting layer and an N-type semiconductor layer, wherein the P-type semiconductor layer is located above the substrate, the light-emitting layer is disposed on the P-type semiconductor layer, and the N-type semiconductor layer is disposed on the light-emitting layer, and wherein the P-type semiconductor layer has a first side and a second side opposite to each other, the substrate is connected to the first side, and the light-emitting layer is connected to the second side,
a P-type electrode, embedded in the P-type semiconductor layer from the second side toward the first side of the P-type semiconductor layer, so that each lateral side of the P-type electrode is at least partially attached to the P-type semiconductor layer, and
an N-type electrode, disposed on the N-type semiconductor layer.

2. The light-emitting diode as claimed in claim **1,** wherein the second side of the P-type semiconductor layer has a setting region, and the setting region is an accommodation space extending from a surface of the second side toward the first side to a default depth.

3. The light-emitting diode as claimed in claim 2, wherein the default depth is less than a thickness of the P-type semiconductor layer and does not exceed 10 µm.

4. The light-emitting diode as claimed in claim 2, wherein the setting region maintains a distance in a horizontal direction away from the light-emitting layer and the N-type semiconductor layer of the semiconductor light-emitting structure.

5. The light-emitting diode as claimed in claim **1,** wherein the P-type semiconductor layer is made of P-type gallium phosphide material, and the N-type semiconductor layer is made of N-type aluminum gallium indium phosphide material.

6. The light-emitting diode as claimed in claim **1,** wherein a cross-sectional area of the P-type electrode along a horizontal direction is not less than 3% of a total cross-sectional area of the light-emitting diode along the horizontal direction.

7. The light-emitting diode as claimed in claim **1,** wherein a default wavelength of the semiconductor light-emitting structure is between 590 nm and 1050 nm.

8. The light-emitting diode as claimed in claim **1,** further comprising a bonding layer sandwiched between the substrate and the P-type semiconductor layer, wherein the bonding layer is made of silicon dioxide material.

9. The light-emitting diode as claimed in claim **1,** wherein the P-type electrode is made of beryllium gold alloy material or zinc gold alloy material.

10. The light-emitting diode as claimed in claim **1,** wherein the substrate is a sapphire substrate.
